(19) Europäisches Patentamt

European Patent Office

Office européen des brevets

(11) **EP 2 510 415 B1**

(12) **FASCICULE DE BREVET EUROPEEN**

(45) Date de publication et mention de la délivrance du brevet:
**23.11.2016 Bulletin 2016/47**

(21) Numéro de dépôt: **10809067.1**

(22) Date de dépôt: **10.12.2010**

(51) Int Cl.:
*H01L 31/02* (2006.01)     *H02M 1/00* (2006.01)
*H02M 3/158* (2006.01)     *H02J 7/35* (2006.01)

(86) Numéro de dépôt international:
**PCT/IB2010/055756**

(87) Numéro de publication internationale:
**WO 2011/070547 (16.06.2011 Gazette 2011/24)**

(54) **SYSTEME DE GESTION ELECTRONIQUE DE CELLULES PHOTOVOLTAIQUES AVEC SEUILS ADAPTES**

ELEKTRONISCHE STEUERVORRICHTUNG MIT ADAPTIERBAREN SCHWELLEN FÜR SOLARZELLEN

ELECTRONIC CONTROL SYSTEM WITH ADAPTIVE THRESHOLDS FOR PHOTOVOLTAIC CELLS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2009 FR 0958899**

(43) Date de publication de la demande:
**17.10.2012 Bulletin 2012/42**

(73) Titulaires:
• **TOTAL MARKETING SERVICES**
  **92800 Puteaux (FR)**
• **Centre National de la Recherche Scientifique**
  **75794 Paris Cedex 16 (FR)**

(72) Inventeurs:
• **ALONSO, Corinne**
  **F-31520 Ramonville Saint Agne (FR)**
• **BERASATEGI, Alona**
  **E-20213 Idiazabal (Guipuzcoa) (ES)**
• **CABAL, Cédric**
  **F-31100 Toulouse (FR)**
• **ESTIBALS, Bruno**
  **F-31470 Saint Thomas (FR)**
• **PETIBON, Stéphane**
  **F-36130 Deols (FR)**
• **VERMEERSCH, Marc**
  **F-78110 Le Vésinet (FR)**

(74) Mandataire: **Croonenbroek, Thomas Jakob**
  **Innovincia**
  **11, avenue des Tilleuls**
  **74200 Thonon-les-Bains (FR)**

(56) Documents cités:
  **EP-A1- 1 047 179**

• **BLAABJERG F ET AL: "A Review of Single-Phase Grid-Connected Inverters for Photovoltaic Modules", IEEE TRANSACTIONS ON INDUSTRY APPLICATIONS, IEEE SERVICE CENTER, PISCATAWAY, NJ, US LNKD-DOI:10.1109/TIA.2004.841166, vol. 41, no. 5, 1 septembre 2005 (2005-09-01), pages 1292-1306, XP011139229, ISSN: 0093-9994**

**Description**

DOMAINE DE L'INVENTION

La présente invention concerne le domaine des générateurs photovoltaïques et plus spécifiquement des modules photovoltaïques intégrant de l'électronique ; un tel module comprend un générateur photo voltaïque et un système de gestion électronique de cellules photovoltaïques.

ARRIERE-PLAN TECHNOLOGIQUE

De manière connue en soi, un générateur photo voltaïque (GPV) comprend une ou plusieurs cellules photovoltaïques (PV) reliées en série et/ou en parallèle. Dans le cas de matériaux inorganiques, une cellule photo voltaïque est essentiellement constituée d'une diode (jonction pn ou pin) composée à partir d'un matériau semi-conducteur. Ce matériau présente la propriété d'absorber de l'énergie lumineuse dont une part significative peut être transférée à des porteurs de charge (électrons et trous). La constitution d'une diode (jonction pn ou pin) par dopage de deux zones respectivement de type N et de type P - éventuellement séparées d'une région non dopée (appelée "intrinsèque" et désignée par "i" dans la jonction pin) - permet de séparer les porteurs de charge pour ensuite les collecter via des électrodes que comporte la cellule photovoltaïque. La différence de potentiel maximale (tension de circuit ouvert, Voc) et le courant maximal (courant de court-circuit, Icc) que peut fournir la cellule photovoltaïque sont fonction à la fois des matériaux constitutifs de l'ensemble de la cellule et des conditions environnant cette cellule (dont l'éclairement au travers de l'intensité spectrale, la température,...). Dans le cas des matériaux organiques, les modèles sont sensiblement différents - faisant davantage référence à la notion de matériaux donneurs et accepteurs dans lesquels sont créés des paires électron-trou appelées excitons. La finalité demeure la même : séparer les porteurs de charge pour collecter et générer un courant.

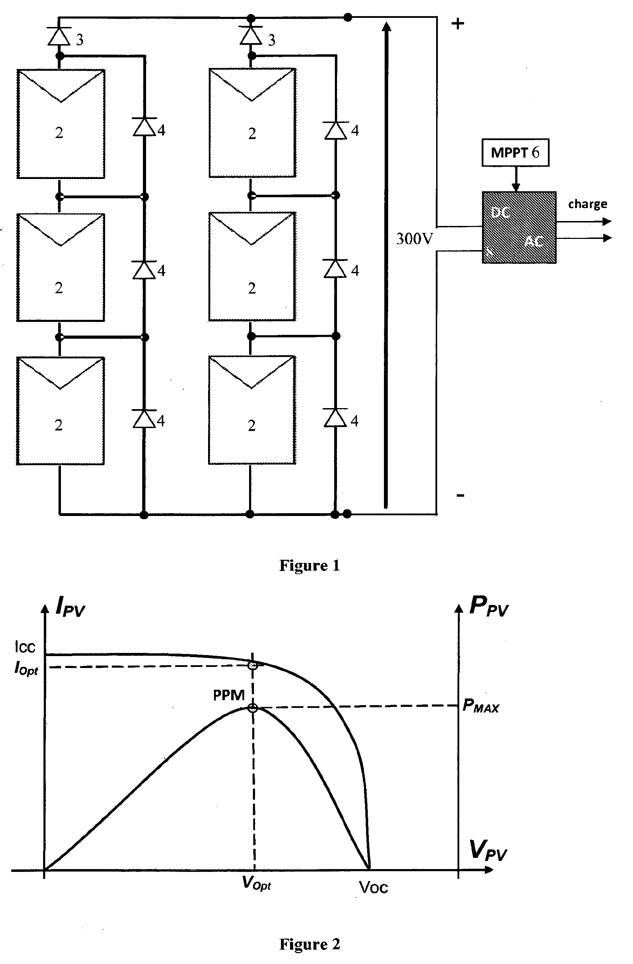

La figure 1 illustre schématiquement un exemple de générateur photovoltaïque (selon l'état de la technique). La plupart des générateurs photovoltaïques sont constitués d'au moins un panneau lui-même constitué de cellules photovoltaïques connectées en série et/ou en parallèle. On peut connecter plusieurs groupes de cellules en série pour augmenter la tension totale du panneau ; on peut également connecter plusieurs groupes de cellules en parallèle pour augmenter l'intensité délivrée par le système. De la même manière, plusieurs panneaux peuvent être reliés en série et/ou en parallèle pour augmenter la tension et/ou l'ampérage du générateur en fonction de l'application.

La figure 1 illustre un générateur photovoltaïque comprenant deux branches parallèles comprenant chacune trois groupes de cellules 2. Afin de garantir la sécurité électrique du générateur photovoltaïque, on peut prévoir des diodes anti-retour 3 et des diodes de dérivation 4 (ou by-pass en terminologie anglaise). Les diodes anti-retour 3 sont branchées en série sur chaque branche parallèle du générateur afin d'éviter la circulation dans les cellules d'un courant négatif arrivant de la charge ou d'autres branches du générateur. Les diodes de dérivation 4 sont branchées en anti-parallèle sur des groupes 2 de cellules. Les diodes de dérivation 4 permettent d'isoler un groupe 2 de cellules présentant une défaillance ou un problème d'ombrage et résolvent le problème de points chauds (ou « hot spot » en terminologie anglaise).

La tension maximale du générateur correspond à la somme des tensions maximales des cellules qui le constituent et le courant maximal que peut délivrer le générateur correspond à la somme des courants maximums des cellules. La tension maximale Voc d'une cellule est atteinte pour une cellule prise à vide, c'est-à-dire pour un courant débité nul (circuit ouvert) et le courant maximal Icc d'une cellule est atteint lorsque ses bornes sont court-circuitées, c'est-à- dire pour une tension nulle aux bornes de la cellule. Les valeurs maximales Voc et Icc dépendent de la technologie et du matériau employés pour réaliser la cellule photovoltaïque. La valeur maximale du courant Icc dépend aussi fortement du niveau d'ensoleillement de la cellule. Une cellule photovoltaïque présente ainsi une caractéristique courant/tension (IPV, VPV) non linéaire et une caractéristique de puissance avec un point de puissance maximal (PPM ou MPP en anglais) qui correspond à des valeurs optimales de tension Vopt et de courant Iopt. La figure 2 représente les caractéristiques courant-tension (Ipv,Vpv) et de puissance- tension (Ppy, VPV) d'une cellule photovoltaïque avec son point de puissance maximal (identifié par PPM sur la figure). De même, un générateur photovoltaïque présentera une caractéristique courant/tension non linéaire et une caractéristique de puissance avec un point de puissance maximal. Si une partie des cellules est ombragée, ou si une ou plusieurs cellules d'un groupe sont défectueuses, le point de puissance maximal MPP de ce groupe sera déplacé.

Il est connu d'optimiser le fonctionnement d'un générateur photovoltaïque par l'utilisation d'une commande de recherche du point de puissance maximal (ou MPPT soit Maximum Power Point Tracker en terminologie anglaise). Une telle commande MPPT peut être associée à un ou plusieurs convertisseur(s) statique(s) (CS) qui, selon les applications, peut être un convertisseur courant continu - courant alternatif (DC/AC selon l'acronyme utilisé en anglais) ou un convertisseur courant continu - courant continu (DC/DC selon l'acronyme utilisé en anglais). La figure 1 montre ainsi un convertisseur statique 8 DC/AC branché en sortie du générateur et récoltant l'énergie électrique produite par l'ensemble des cellules du générateur pour la délivrer à une charge. Selon les besoins de la charge, le convertisseur peut être amené à augmenter ou abaisser la tension de sortie et/ou à onduler la tension de sortie. La figure 1 montre aussi une commande MPPT 6 associée au convertisseur 8. La commande MPPT 6 est conçue pour commander le ou les convertisseur(s) 8 afin d'obtenir une tension d'entrée qui corresponde à la valeur optimale de tension Vopt du générateur photovoltaïque (GPV), correspondant au point maximal de la caractéristique de puissance. Le point de puissance maximal dépend de plusieurs paramètres variables au cours du temps, notamment l'ensoleillement en présence, la température ou le vieillissement des cellules ou le nombre de cellules en état de fonctionnement.

De cette manière, le rendement du générateur photovoltaïque n'est pas trop affecté par le dysfonctionnement ou l'ombrage de certaines cellules. Le rendement électrique du générateur dépend directement de l'état de chaque cellule photovoltaïque.

En fonction de l'ensoleillement, la puissance délivrée par le générateur photovoltaïque va varier. Notamment, on pourra utiliser en fonction de la puissance non pas un mais deux ou trois, voire plus, convertisseurs. La méthode consiste à adapter le nombre de convertisseurs (de cellules ou de phases) en fonction de l'évolution de la puissance produite par le GPV. En effet, l'utilisation d'un seul convertisseur n'est pas forcément avantageuse pour gérer de grandes variations de puissance, le rendement de conversion étant affecté. Un convertisseur de puissance constitué à partir d'une seule phase (ou d'un seul convertisseur) a son rendement qui diminue lorsque la puissance PV fournie est maximale, tandis que la structure comprenant trois convertisseurs a tendance à maintenir un rendement quasi-constant quelque soit la puissance PV délivrée. Ce qui va se traduire par un transfert d'énergie à la batterie plus important.

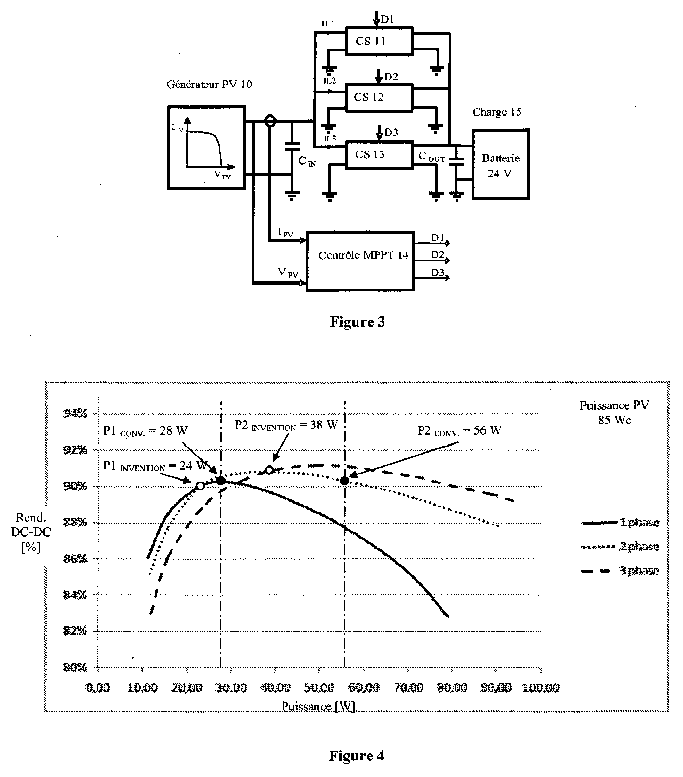

La figure 3 représente un tel arrangement, comprenant à la sortie des cellules PV trois CS (qui sont ici des convertisseurs élévateurs ou BOOST). Ces convertisseurs sont actionnés en fonction de la puissance générée, par rapport à la puissance crête du dispositif (Pcrête). De façon connue, lorsque la puissance délivrée par le GPV est inférieure ou égale à un tiers de la Pcrête, on utilise un CS ; lorsque la puissance délivrée par le GPV est comprise entre 1/3 et 2/3 de la Pcrête, on utilise 2 CS et lorsque la puissance délivrée est supérieure à 2/3 de Pcrête, on utilise 3 CS. Le document EP1047179 décrit également un système de conversion de puissance comprenant plusieurs convertisseurs disposés en parallèle et actionnés en fonction de la puissance générée.

Il existe cependant un besoin pour augmenter le rendement de conversion d'un GPV.

RESUME DE L'INVENTION

L'invention fournit donc un système de gestion électronique d'un générateur photovoltaïque, le système comprenant :

- une pluralité de n convertisseurs (11, 12, 13) statiques associés en parallèle, chaque convertisseur (11, 12, 13) étant connecté électriquement à au moins une cellule (10) photovoltaïque dudit générateur,
- le nombre de convertisseurs connectés étant déterminé par comparaison de la puissance générée à des seuils P1, P2, ... Pn-1, ces seuils étant définis comme les valeurs des puissances sensiblement au point d'intersection des courbes de rendement pour un nombre croissant de convertisseurs.

Selon un mode de réalisation, n vaut 3.

Selon un mode de réalisation, le premier seuil est inférieur à 1/3, de préférence compris entre 20 et 33%, avantageusement entre 23 et 32 %.

Selon un mode de réalisation, le second seuil est inférieur à 2/3, de préférence compris entre 35 et 55%, avantageusement entre 40 et 50 %.

Selon un mode de réalisation, les valeurs de seuil sont fonction de la valeur de tension optimale $V_{opt}$ de ladite au moins une cellule photovoltaïque.

Selon un mode de réalisation, les valeurs de seuil sont fonction de la tension d'entrée des convertisseurs, avantageusement la tension d'entrée est la valeur de tension optimale $V_{opt}$ de ladite au moins une cellule photovoltaïque.

Selon un mode de réalisation, les valeurs de seuil sont fonction de la période de l'année et/ou de l'ensoleillement.

Selon un mode de réalisation, les valeurs de seuil sont fonction du rapport cyclique des convertisseurs.

Selon un mode de réalisation, les valeurs de seuil sont fonction de la température des convertisseurs.

Selon un mode de réalisation, les valeurs de seuil sont fonction du vieillissement des convertisseurs.

Selon un mode de réalisation, les valeurs de seuil sont déterminées et stockées dans la mémoire du système de gestion, les valeurs de seuils appliquées étant susceptibles d'être modifiées en fonction de la mesure d'un paramètre du générateur photovoltaïque.

Selon un mode de réalisation, le système comprend un dispositif de détermination de la courbe de rendement en fonction de la puissance.

Selon un mode de réalisation dit de rotation des CS, dans le système, les convertisseurs sont connectés à tour de rôle.

Selon une variante de ce mode de réalisation avec rotation des CS, la rotation des convertisseurs se fait lors de la variation du nombre de convertisseurs engagés.

Selon une variante de ce mode de réalisation avec rotation des CS, la rotation des convertisseurs dépend de l'état des composants des convertisseurs.

L'invention a encore pour objet un générateur photovoltaïque comprenant :

- au moins une cellule photovoltaïque ;
- le système de gestion selon l'invention.

L'invention a encore pour objet un procédé de commande d'un générateur photovoltaïque comprenant :

- au moins une cellule photovoltaïque ;
- une pluralité de n convertisseurs (11, 12, 13) statiques associés en parallèle, chaque convertisseur (11, 12, 13) étant connecté électriquement à au moins une cellule (10) photovoltaïque ;

ledit procédé comprenant les étapes de :

- détermination de la puissance générée par ladite au moins une cellule photovoltaïque et comparaison avec la puissance de crête ;
- comparaison avec des valeurs seuils P1, P2, ... Pn-1 ;
- ces seuils P1, P2, ... Pn-1, étant définis comme les valeurs des puissances sensiblement au point d'intersection des courbes de rendement pour un nombre croissant de convertisseurs au moins une cellule photovoltaïque ;
- connexion de i convertisseurs lorsque la valeur de puissance mesurée est comprise entre Pi-1 et Pi ou de tous les convertisseurs si la valeur de puissance mesurée est supérieure à Pn-1.

Selon un mode de réalisation dit de rotation des CS, dans le procédé selon l'invention :

- le ième convertisseur n'étant plus connecté lors de la connexion des autres convertisseurs lorsque tous les convertisseurs ne sont pas connectés.

Selon une variante de ce mode de réalisation avec rotation des CS, le procédé comprend les étapes de :

- connexion d'au moins un premier convertisseur ;
- connexion d'un nombre plus élevé de convertisseurs ;
- puis lors de la connexion d'un nombre moins élevé de convertisseurs, ledit premier convertisseur n'est pas connecté.

Selon une variante de ce mode de réalisation avec rotation des CS, dans le procédé, l'étape de rotation des convertisseurs s'effectue lorsque la valeur de puissance mesurée change entre les seuils Pi-1 et Pi.

Selon une variante de ce mode de réalisation avec rotation des CS, le procédé comprend les étapes de :

- détermination de la durée d'utilisation et/ou du nombre d'utilisation de chaque convertisseur ;
- connexion des convertisseurs tels que la durée d'utilisation et/ou le nombre d'utilisation est sensiblement égal pour les convertisseurs sur une période donnée.

Les procédés de l'invention sont particulièrement adaptés aux générateurs selon l'invention.

BREVE DESCRIPTION DES DESSINS

Dans les dessins annexés :

- figure 1, déjà décrite, un schéma d'un générateur photovoltaïque de l'état de la technique ;
- figure 2, déjà décrite, des caractéristiques courant-tension et de puissance théoriques d'une cellule photovoltaïque ;
- figure 3, montre un schéma d'un GPV comprenant plusieurs convertisseurs (ici 3 convertisseurs statiques CS type BOOST) ;
- figure 4, montre les courbes de rendement pour 3 CS ;
- figure 5, montre le nombre de CS en fonction de l'heure de la journée avec l'invention
- figure 6, montre le schéma utilisé dans les exemples.

DESCRIPTION DETAILLEE DE MODES DE REALISATION DE L'INVENTION.

L'invention propose un système de gestion électronique d'un générateur photovoltaïque comprenant une pluralité de convertisseurs (de cellules ou de phases) qui peuvent être DC/AC ou DC/DC, typiquement trois convertisseurs, reliés à des cellules photovoltaïques. Les convertisseurs sont connectés électriquement à au moins une cellule photovoltaïque afin de récolter l'énergie produite par cette cellule et la transférer vers une charge. On appelle « charge » l'application électrique à laquelle est destinée l'énergie produite par le générateur photovoltaïque. La description qui suit est donnée en référence à 3 convertisseurs, mais il est entendu que l'invention s'applique identiquement à un nombre supérieur. CS sera l'acronyme utilisé dans ce qui suit pour désigner un convertisseur (ici statique).

Ces convertisseurs sont, de façon classique, commandés par une commande dite MPPT. Par exemple, cette commande de recherche du point de puissance maximal MPPT peut mettre en oeuvre un algorithme qui identifie l'influence d'un changement de tension sur la puissance délivrée par le générateur et provoque un décalage de la tension dans le sens identifié comme accroissant la puissance. Ainsi, un tel algorithme consiste à mesurer la puissance délivrée par le générateur pour une première tension et, après un certain temps, à imposer une deuxième tension supérieure à la première puis mesurer ou estimer la puissance correspondante. Dans le cas où la puissance correspondant à la seconde tension est supérieure à la puissance correspondant à la première tension, l'étape suivante de l'algorithme est d'imposer une troisième tension encore plus grande. Dans le cas contraire, la troisième tension appliquée est plus faible que la première tension. Ainsi, de proche en proche, le système peut adapter en permanence la tension aux bornes du générateur photovoltaïque afin de se rapprocher le plus possible du point de puissance maximum. Il est entendu que d'autres algorithmes peuvent être mis en oeuvre pour la commande MPPT.

La figure 3 représente un tel schéma, et le GPV comprend une unité photovoltaïque 10, reliée à des CS 11, 12 et 13 (BOOST 1, 2 et 3) et à une commande MPPT 14, la sortie des CS étant reliée à une batterie 15.

La commande des convertisseurs intègre les courbes de rendement pour les convertisseurs. Une telle courbe est donnée à la figure 4. Sur cette figure, on a représenté le rendement pour une phase, pour deux phases et pour trois phases. Pcrête est donnée à titre d'exemple à 85W. On note que pour une phase, le rendement augmente jusqu'au point environ à 1/3 de Pcrête. Pour deux phases, le rendement augmente jusqu'à un point à une valeur comprise entre environ 35W et 40W. Pour 3 phases, le rendement est supérieur à partir de ce point.

L'application de l'état de la technique correspond à deux seuils prédéterminés de changement du nombre de convertisseur. En fonction de la puissance mesurée par le système de gestion MPPT, savoir moins de 1/3 Pcrête, entre 1/3 et 2/3 Pcrête et plus de 2/3 Pcrête, alors le système de gestion engage un, deux ou trois convertisseurs.

L'invention prend en compte la courbe vraie du rendement en fonction du nombre de convertisseurs. On cherche alors à optimiser le rendement en fonction du nombre de convertisseurs, et on détermine les points d'intersection des courbes de puissance des convertisseurs en fonction de leur nombre. Ainsi, sur la figure 4, le premier point d'intersection entre la courbe de rendement pour un convertisseur et pour deux convertisseurs donne le premier seuil P1, seuil qui sera alors stocké dans la mémoire du système de gestion. Lorsque la puissance délivrée par les cellules PV sera inférieure à ce seuil, un CS sera engagé, tandis que lorsque la puissance est supérieure à ce seuil P1, alors 2 CS seront engagés. La figure 4 montre aussi le point d'intersection entre la courbe avec 2 CS et celle avec 3 CS. On note que le seuil à partir duquel le rendement est supérieur est fortement décalé du point à 2/3. Ce second point est le seuil P2, en-dessous duquel on engage 2 CS et au-dessus duquel on engage 3 CS en fonction de la puissance délivrée par les cellules PV et leur comparaison par rapport à Pcrête.

L'état de la technique est basé sur un découpage par tiers dans le cas de 3 convertisseurs, en partant du postulat que le rendement serait optimal pour un nombre optimal de convertisseurs. Pour 3 convertisseurs, le nombre optimal est de 1, 2 ou 3, et la plage a été divisée en 3. L'invention se démarque de ce postulat, en adoptant des valeurs seuils au plus près de la réalité de la puissance convertie. On constate sur la figure 4 que le rendement est maximal avec l'invention.

Les valeurs de P1 et P2 sont, dans le cas représenté, respectivement de 28% et de 45%. De façon générale, le seuil P1 est inférieur à 1/3, et il est typiquement compris entre 20 et 33%, avantageusement entre 23 et 32%. De façon générale, le seuil P2 est inférieur à 2/3, et il est typiquement compris entre 35 et 55%, avantageusement entre 40 et 50%. Bien entendu, d'autres valeurs peuvent être déterminées en fonction des dispositifs utilisés.

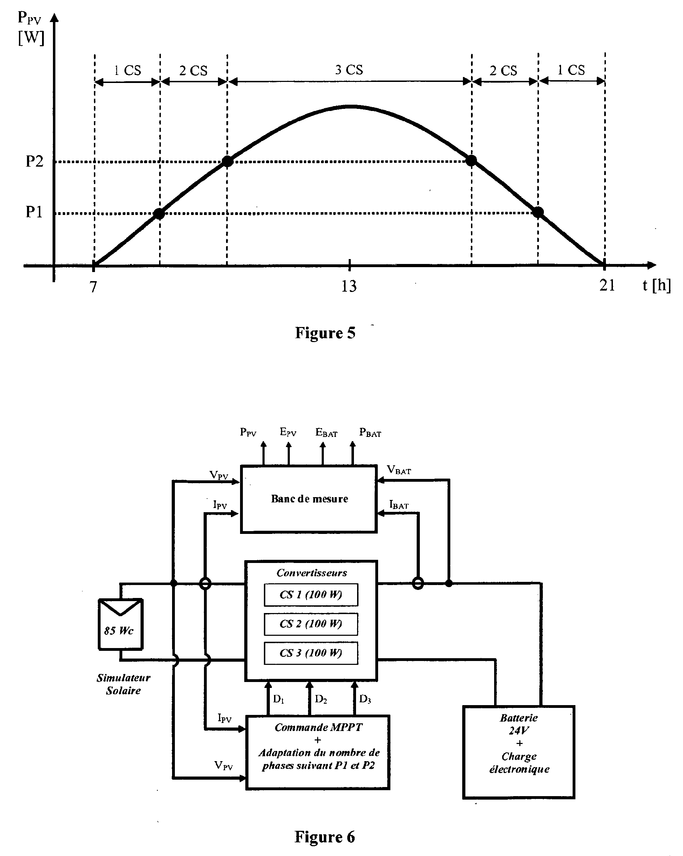

Ainsi, en fonction de l'heure de la journée, on utilise un nombre approprié de CS. La figure 5 représente le nombre de CS en fonction de l'heure de la journée. Le mode de réalisation avec 3 CS est celui majoritaire au cours de la journée, alors qu'il ne représentait qu'un tiers selon l'état de la technique.

Le même principe est applicable à n convertisseurs, que ce soit 2, 3, 4 ou plus, le nombre de convertisseurs connectés (sur un total de n convertisseurs) étant déterminé par comparaison de la puissance générée à des seuils P1, P2, ... Pn-1, ces seuils étant définis comme les valeurs des puissances au point d'intersection des courbes de rendement pour un nombre croissant de convertisseurs, le seuil P1 étant l'intersection entre les courbes de rendement de 1 et de 2 convertisseurs, le seuil Pn-1 étant l'intersection entre les courbes de rendement de n-1 et n convertisseurs.

Les valeurs de seuils P1 et P2 varient en fonction des appareils utilisés pour la fabrication des GPV. Il est possible de mesurer les courbes de rendement des CS en fonction du nombre de phases, à savoir tracer la courbe de la figure 4 _ et de stocker ces valeurs dans la mémoire du système de gestion. Ces valeurs seront alors utilisées par le système sans modification.

Il est aussi possible de prendre en compte les facteurs qui influencent les courbes de rendement.

On peut notamment prendre en compte la saison de l'année et/ou les caractéristiques des dispositifs électroniques eux-mêmes.

La saison de l'année est un facteur qui peut être pris en compte, car la température du panneau PV varie en fonction des saisons. Les caractéristiques du panneau varient aussi en fonction des saisons, notamment la valeur optimale de tension $V_{opt}$ qui varie en fonction de la période de l'année. A titre d'exemple, on peut avoir une variation de la valeur optimale de tension $V_{opt}$ comme suit (la valeur de la tension optimale diminuant lorsque la température du panneau augmente) :

| Hiver | Printemps | Eté | Automne |
|-------|-----------|------|---------|
| 18V | 16V | 14,5V | 17V |

En fonction de la valeur optimale de tension $V_{opt}$, les valeurs de seuil vont aussi varier. On pourra par exemple avoir les valeurs de seuil P1 et P2, exprimées en % de Pcrête, comme suit (les valeurs précédentes de 28% et de 45% sont réputées être obtenues en automne, à tire d'exemple).

|  | Hiver 18V | Printemps 16V | Eté 14,5V | Automne 17V |
|--|-----------|---------------|-----------|-------------|
| P1 (%Pcrête) | 24 | 29 | 32 | 28 |
| P2 (%Pcrête) | 41 | 47 | 47 | 45 |

On peut donc adapter les valeurs des seuils P1 et P2 en fonction de la saison, après avoir stocké ces valeurs dans la mémoire du système de gestion (et on les applique en fonction d'un calendrier), ou alors utiliser les valeurs optimales de tension $V_{opt}$ mesurées par le système (le MPPT) pour appliquer des valeurs de seuils P1 et P2 associés, la mémoire du système comprenant une correspondance entre les différentes valeurs de tension et de seuils.

La valeur de la tension optimale $V_{opt}$ peut encore varier en fonction de l'ensoleillement, avec des valeurs qui en général diminuent lorsque le niveau d'ensoleillement diminue.

Par ailleurs, le rendement d'un convertisseur varie en fonction des caractéristiques de celui-ci. Notamment, le rendement d'un convertisseur peut varier en fonction du rapport cyclique, de la température de l'élément et de son vieillissement.

Le rendement d'un convertisseur de puissance peut être défini comme la capacité de ce dernier à restituer sur son port de sortie, le maximum de la puissance présente sur son port d'entrée, la différence par rapport à 100% étant les pertes.

Dans le cas d'un convertisseur élévateur DC/DC (dit « BOOST »), classiquement utilisé dans les GPV, les pertes correspondent aux pertes joules des composants passifs et de la connectique, ainsi que les pertes par conduction et par commutation des éléments actifs (transistor à effet de champ et diode).

Ces pertes vont varier principalement en fonction de trois principaux paramètres qui sont le rapport cyclique, la température et le vieillissement, leur importance relative étant en général dans cet ordre.

Ainsi, le rendement d'un convertisseur est en général fonction du rapport cyclique.

Le rapport cyclique est défini (pour un convertisseur élévateur) comme suit :

$$\alpha = 1 - V_{in}/V_{out}$$

La tension de sortie $V_{out}$, à savoir la tension de la batterie, pourra donc influencer le rapport cyclique, par exemple en cas de sur ou sous-charge, ou lors du remplacement par une batterie d'une tension nominale différente.

La tension $V_{in}$ peut également affecter la valeur du rapport cyclique. Dans les applications photovoltaïques avec commande MPPT, cette tension correspond à la tension optimale du panneau ($V_{opt}$), tension où la puissance produite par le GPV est maximale. Or, on a vu plus haut que cette tension peut varier notamment en fonction des saisons (température du panneau) et de l'ensoleillement.

Pour tenir compte du rapport cyclique, le système de gestion pourra procéder à des mesures des tensions aux bornes du convertisseur et adapter les seuils en conséquence. La valeur de tension optimale ($V_{opt}$) étant déjà mesurée par ailleurs, on utilisera la mesure de cette valeur lors de la détermination du rapport cyclique, qui pourra donc être déterminé en même temps que cette valeur de tension optimale.

Ainsi, le rendement d'un convertisseur est en général fonction de la température des composants, notamment du transistor à effet de champ et de la diode. Pour le transistor, la résistance croit lorsque la température de jonction augmente, entraînant ainsi une élévation des pertes par conduction. Pour la diode, l'effet est inverse, les pertes en conduction diminuant lorsque la température augmente. Cependant, les effets sont très difficiles à prévoir, en particulier car ceux-ci découlent d'une utilisation en commun dans un convertisseur. De façon générale, le rendement d'un convertisseur est fonction de la température, le rendement variant lors des variations de température.

Pour tenir compte de la température, une ou plusieurs sondes thermiques peuvent être prévues pour mesurer la température des composants et injecter le résultat de la mesure dans le système de gestion.

Ainsi, le rendement d'un convertisseur est en général fonction de son vieillissement. La résistance du transistor augmente lors du vieillissement, de même que la valeur de la tension de seuil pour la diode. Le vieillissement ou un fonctionnement prolongé a pour effet de modifier le comportement électrique des composants actifs ainsi qu'une augmentation des pertes, se traduisant par une modification du comportement du rendement du convertisseur.

Pour tenir compte du vieillissement, un compteur peut être prévu pour mesurer par exemple le nombre de cycles de la diode et en déterminer un âge du système électronique.

Il est encore possible de déterminer « on site » les courbes de rendement en intégrant un banc de mesure au système de gestion du GPV. Dans un tel cas, le système procédera à la mesure des seuils P1 et P2 selon une routine préenregistrée, à des temps prédéterminés (à une date et/ou une heure données), à des intervalles prédéterminés, après une valeur d'énergie délivrée prédéterminée, etc., ou alors encore de façon aléatoire. Il est sinon possible de stocker dans la mémoire du système de gestion les valeurs de P1 et P2 correspondant à chaque situation rencontrée lors de la mise en oeuvre d'un GPV. Il est aussi possible de procéder de façon hybride, savoir une partie des informations est stockée et une autre partie est mesurée. Par exemple, les valeurs des saisons sont stockées tandis que la température des composants est mesurée.

Selon un mode de réalisation avantageux, le système intègre une routine de rotation des CS pour éviter la sollicitation en continue d'un seul CS. En effet, dans la figure 3, le convertisseur CS 11 est relié en permanence, et donc reçoit le courant à convertir en permanence. Les autres CS sont utilisés en fonction des changements intervenant dans la génération de la puissance PV. Le CS 11 est donc sollicité en permanence, et est soumis en outre à des changements de puissance à traiter lors des variations de puissance PV. La fiabilité du système est donc diminuée puisqu'un des composants est sollicité en permanence. Selon le mode de réalisation avantageux, il y a une rotation des CS engagés.

La rotation peut être commandée lors des changements de puissance PV générée par les panneaux ou peut être commandée en fonction de l'état des convertisseurs, ou les deux. Une commande aléatoire d'affectation peut aussi être utilisée.

Selon un mode de réalisation, le changement de CS a lieu lors de l'augmentation du nombre de CS engagés. Par exemple, si le CS 11 est connecté, et que la commande détermine qu'il faut utiliser 2 CS, alors ce seront les CS 12 et 13 qui seront engagés, tandis que le CS 11 ne sera plus connecté. Si le nombre de CS revient à une unité, alors ce sera le CS 12 (ou CS 13) qui sera connecté, plutôt que le CS 11 qui sera encore au repos. Dans le cas où les 3 CS doivent être connectés, la rotation a lieu lors du retour à 1 ou 2 CS. Dans ce cas, on part d'une situation ou le CS 11 est connecté, puis les 3 CS sont connectés, puis les conditions de retour requièrent 2 CS alors les CS 12 et 13 sont connectés ou si les conditions de retour requièrent seulement 1 CS, ce sera le CS 12 ou 13 qui sera connecté.

Selon un autre mode de réalisation, le changement de CS a lieu du fait d'un calcul d'utilisation des CS. Ce calcul peut être basé sur la durée d'utilisation, la rotation se fait de sorte à assurer une durée d'utilisation sensiblement égale pour tous les CS, sur une période donnée. Cette période peut être une journée, plusieurs journées ou une fraction de journée, par exemple une ou plusieurs heures, cette durée pouvant aussi être fonction de l'heure de la journée et/ou de la saison. Ainsi, selon ce mode de réalisation, le CS qui doit être engagé est celui qui a été le moins utilisé, savoir celui ayant eu le temps d'utilisation le plus faible. Le calcul peut aussi se faire en comptant non pas la durée mais le nombre d'utilisation ou de sollicitations du CS, indépendamment de la durée d'utilisation. Ainsi, selon ce cas, le CS qui doit être engagé est celui qui a été sollicité le moins de fois. Il est aussi possible d'envisager un mode de réalisation dans lequel les deux variantes sont associées.

Selon un autre mode de réalisation, il est possible que la rotation se fasse de façon aléatoire, un générateur aléatoire étant alors prévu dans le système de gestion. Lors de l'augmentation ou de la baisse du nombre de CS, le choix se fait de façon aléatoire, éventuellement en mode dit « shuffle » si besoin (ce mode correspond à un mode dans lequel le CS qui a été utilisé est exclu de la sélection aléatoire).

Dans ce qui a été décrit ci-dessus, la rotation des CS se fait lors du changement du nombre de CS engagés. Il est bien entendu possible de prévoir que cette rotation se fasse lorsque le nombre de CS engagés est constant (pour autant qu'il soit différent du nombre maximal). Ainsi, lorsque les conditions météorologiques sont telles que seul un CS est engagé, on peut prévoir une routine qui échange ce CS avec un CS initialement au repos, de sorte qu'un CS ne soit pas utilisé en continu plus d'une durée donnée.

La rotation des convertisseurs engagés a pour effet de réduire les stress thermique et électrique subis par les composants actifs lors des variations de puissance.

Les variations thermiques induisent des contraintes mécaniques au niveau des semiconducteurs, dues en grande partie à la différence au niveau des coefficients de dilatation des matériaux utilisé lors de la fabrication, par exemple 4 ppm/°C pour le silicium contre 16 ppm/°C pour le cuivre et 24 ppm/°C pour l'aluminium. Le résultat des contraintes mécaniques subies par des contacts électriques après de nombreux cycles thermiques est l'apparition de microfissures sur les contacts, allant même jusqu'à la rupture de celui-ci. Le mode de réalisation de rotation des CS a pour but de répartir sur tous les convertisseurs le stress thermique et électrique.

Le système de gestion électronique selon l'invention peut également inclure des fonctions de sécurité, commandant l'arrêt des convertisseurs, suite à un message par exemple de surchauffe des composants du GPV. Le système de gestion électronique selon l'invention peut également inclure une fonction anti-vol. Le système de gestion selon l'invention peut en outre transmettre des informations relatives à l'état de fonctionnement des groupes de cellules et/ou des convertisseurs à un central d'un réseau électrique. Cela permet de faciliter la maintenance des GPV. En particulier, l'opérateur chargé de la maintenance est ainsi averti plus vite d'un dysfonctionnement de certains groupes de cellules photovoltaïques ou de certains convertisseurs et peut prendre des mesures en conséquence.

Le système de gestion selon l'invention peut être tout ou partie intégré dans un générateur photovoltaïque.

Selon un mode de réalisation possible, des dispositifs photovoltaïques multi-jonctions peuvent être utilisés. Il devient alors nécessaire de gérer le problème du couplage électrique des différentes jonctions. Un dispositif photovoltaïque multi jonctions, par exemple à jonction tandem, désigne un dispositif photovoltaïque constitué de plusieurs jonctions simples empilées de façon à accroître la zone d'absorption de spectre solaire par le dispositif. Les dispositifs photovoltaïques à jonction tandem permettent d'obtenir un meilleur rendement de conversion électrique. L'inconvénient principal du couplage électrique dans un dispositif photovoltaïque à jonction tandem est la nécessité d'un accord des performances des cellules photovoltaïques constituant le tandem, quelles que soient les conditions d'ensoleillement. Ce cas idéal n'est pas accessible dans la réalité car la production de courant de chaque cellule du tandem est volontairement différente suivant la région du spectre où elles sont actives et varie en fonction des conditions d'ensoleillement. Il en résulte une limitation intrinsèque du dispositif photovoltaïque à jonction tandem par le plus faible de ses éléments. Une telle limitation en courant réduit fortement le rendement théorique d'un dispositif photovoltaïque à jonction tandem. Une solution consiste à dissocier électriquement les jonctions d'un dispositif photovoltaïque à jonction tandem. Les cellules photovoltaïques du tandem sont toujours couplées optiquement mais sont découplées électriquement. Chaque jonction est alors associée à deux électrodes électriques ; on obtient ainsi un dispositif photovoltaïque à quatre électrodes (dans le cas d'un tandem). En reliant les convertisseurs à chaque (au moins une) cellule photovoltaïque du tandem, le système permet d'obtenir un dispositif photovoltaïque multi-jonctions fonctionnant avec des cellules photovoltaïques découplées électriquement et gérées chacune de manière optimale via le système de gestion selon l'invention.

Les exemples suivants illustrent l'invention sans la limiter.

## EXEMPLE

Dans cet exemple, on compare un système comprenant 3 CS, mis en oeuvre selon l'état de la technique avec des seuils fixés à 1/3 et 2/3 de PV crête et un système comprenant 3 CS, mis en oeuvre selon l'invention.

Le protocole de test retenu pour évaluer le gain énergétique apporté par la méthode selon l'invention a consisté à utiliser la même source d'entrée (simulateur solaire) et la même carte de puissance multi-phases (comportement des composants électriques identiques). Le simulateur a permis d'appliquer dans les deux cas le même profil de puissance (par exemple la production d'un module d'une puissance crête de 85 W sur une journée relativement ensoleillée), tandis que l'obtention du MPP a été réalisée par la même commande MPPT, ou seules les valeurs de P1 et P2 ont différées.

Durant cet essai, une batterie de 24 V a été utilisée, à laquelle a été associée une charge électronique afin de garantir en permanence la tension nominale de cette dernière (24 V). La figure 6 représente le schéma de mesure utilisé.

A partir du banc de mesure on mesure simultanément le courant et la tension présents à l'entrée et à la sortie du convertisseur. Ces valeurs permettent de déduire la puissance PV ($P_{PV}$) fournie par le simulateur et la puissance transmise à la batterie ($P_{BAT}$) et donc le rendement du convertisseur ($P_{BAT}$ / $P_{PV}$). En prenant en compte la variable temps (durée du test en heure) on calcule alors la quantité d'énergie PV produite ($E_{PV}$) et transférée à la batterie ($E_{BAT}$).

La détermination des seuils P1 et P2 selon la méthode de l'invention est représentée à la figure 4. Les seuils sont respectivement de 28% et de 45%.

On obtient les résultats suivants, le comparatif correspondant à des seuils à 1/3 et 2/3, conformément à l'état de la technique :

|  | Énergie PV [Wh] | Énergie Batterie [Wh] | Rendement dc-dc [%] |
|---|---|---|---|
| Comparatif | 387.4 | 344 | 88.8 |

(suite)

| | Énergie PV [Wh] | Énergie Batterie [Wh] | Rendement dc-dc [%] |
|---|---|---|---|
| Invention | 387.6 | 346.8 | 89.5 |

Lors de ce test, les deux systèmes ont reçu approximativement la même quantité d'énergie sur leur port d'entrée, soit 387 Wh. Le système où les seuils ont été déterminés par la méthode selon l'invention a permis de transférer 2.4 Wh de plus à la charge, ce traduisant au final par un gain au niveau du rendement de conversion de l'étage de puissance de 0.7 %.

## Revendications

1. Un système de gestion électronique d'un générateur photovoltaïque, le système comprenant :

   - une pluralité de convertisseurs (11, 12, 13) statiques associés en parallèle, chaque convertisseur (11, 12, 13) étant connecté électriquement à au moins une cellule (10) photovoltaïque dudit générateur, le nombre de convertisseurs statiques étant appelé n,
   - le nombre de convertisseurs connectés étant déterminé par comparaison de la puissance générée à des seuils P1, P2, ... Pn-1 **caractérisé en ce que** ces seuils sont définis comme les valeurs des puissances sensiblement au point d'intersection des courbes de rendement pour un nombre croissant de convertisseurs.

2. Le système selon la revendication 1, dans lequel le premier seuil est inférieur à 1/3, de préférence compris entre 20 et 33%, avantageusement entre 23 et 32%, et dans lequel le second seuil est inférieur à 2/3, de préférence compris entre 35 et 55%, avantageusement entre 40 et 50%.

3. Le système selon la revendication 1 ou 2, dans lequel les valeurs de seuil sont fonction de la valeur de tension optimale ($V_{opt}$) de ladite au moins une cellule photovoltaïque.

4. Le système selon l'une quelconque des revendications 1 à 3, dans lequel les valeurs de seuil sont fonction de la tension d'entrée des convertisseurs, avantageusement la tension d'entrée est la valeur de tension optimale ($V_{opt}$) de ladite au moins une cellule photovoltaïque.

5. Le système selon la revendication 3 ou 4, dans lequel les valeurs de seuil sont fonction de la période de l'année et/ou de l'ensoleillement.

6. Le système selon l'une des revendications 1 à 5, dans lequel les valeurs de seuil sont fonction du rapport cyclique des convertisseurs.

7. Le système selon l'une des revendications 1 à 6, dans lequel les valeurs de seuil sont fonction de la température des convertisseurs.

8. Le système selon l'une des revendications 1 à 7, dans lequel les valeurs de seuil sont fonction du vieillissement des convertisseurs.

9. Le système selon l'une des revendications 1 à 8, dans lequel les valeurs de seuil sont déterminées et stockées dans la mémoire du système de gestion, les valeurs de seuils appliquées étant susceptibles d'être modifiées en fonction de la mesure d'un paramètre du générateur photovoltaïque.

10. Le système selon l'une des revendications 1 à 9, comprenant un dispositif de détermination de la courbe de rendement en fonction de la puissance.

11. Le système selon l'une des revendications 1 à 10, dans lequel le système comprend une routine de rotation des convertisseurs engagés.

12. Le système selon la revendication 11, dans lequel la rotation des convertisseurs se fait lors de la variation du nombre de convertisseurs engagés.

**13.** Un générateur photovoltaïque comprenant :

- au moins une cellule photovoltaïque;
- le système de gestion selon l'une des revendications 1 à 12.

**14.** Procédé de commande d'un générateur photovoltaïque comprenant:

- au moins une cellule photovoltaïque;
- une pluralité de n convertisseurs (11, 12, 13) statiques associés en parallèle, chaque convertisseur (11, 12, 13) étant connecté électriquement à au moins une cellule (10) photovoltaïque, le nombre de convertisseurs statiques étant appelé n; ledit procédé comprenant les étapes de
- détermination de la puissance générée par ladite au moins une cellule photovoltaïque et comparaison avec la puissance de crête;
- comparaison avec des valeurs seuils P1, P2, ... Pn-1;
- connexion de i convertisseurs lorsque la valeur de puissance mesurée est comprise entre Pi-1 et Pi ou de tous les convertisseurs si la valeur de puissance mesurée est supérieure à Pn-1

**caractérisé en ce que** lesdits seuils P1, P2, ... Pn-1 sont définis comme les valeurs des puissances sensiblement au point d'intersection des courbes de rendement pour un nombre croissant de convertisseurs.

**15.** Procédé selon la revendication 14, dans lequel :

- le (n-i)ème convertisseur n'étant plus connecté lors de la connexion des autres convertisseurs lorsque tous les convertisseurs ne sont pas connectés.

**16.** Procédé selon la revendication 15, ledit procédé comprenant les étapes de :

- connexion d'au moins un premier convertisseur ;
- connexion d'un nombre plus élevé de convertisseurs ;
- puis lors de la connexion d'un nombre moins élevé de convertisseurs, ledit premier convertisseur n'est pas connecté.

**17.** Procédé selon l'une des revendications 15 ou 16 , dans lequel l'étape de rotation des convertisseurs s'effectue lorsque la valeur de puissance mesurée change entre les seuils Pi-1 et Pi.

**18.** Procédé selon l'une des revendications 15 à 17, ledit procédé comprenant les étapes de :

- détermination de la durée d'utilisation et/ou du nombre d'utilisation de chaque convertisseur ;
- connexion des convertisseurs tels que la durée d'utilisation et/ou le nombre d'utilisation est sensiblement égal pour les convertisseurs sur une période donnée.


**Patentansprüche**

**1.** Elektronisches Steuersystem für einen photovoltaischen Generator, wobei das System Folgendes umfasst:

- mehrere parallel geschaltete statische Umsetzer (11, 12, 13), wobei jeder Umsetzer (11, 12, 13) mit wenigstens einer photovoltaischen Zelle (10) des Generators elektrisch verbunden ist, wobei die Anzahl statischer Umsetzer n genannt wird,
- wobei die Anzahl verbundener Umsetzer durch Vergleichen der erzeugten Leistung mit Schwellenwerten P1, P2, ..., Pn - 1 bestimmt wird, **dadurch gekennzeichnet, dass** diese Schwellenwerte als die Werte von Leistungen im Wesentlichen im Schnittpunkt von Wirkungsgradkurven für eine zunehmende Anzahl von Umsetzern definiert sind.

**2.** System nach Anspruch 1, wobei der erste Schwellenwert kleiner als 1/3 ist und vorzugsweise im Bereich von 20 bis 33 %, vorteilhaft von 23 bis 32 %, liegt und wobei der zweite Schwellenwert kleiner als 2/3 ist und vorzugsweise im Bereich von 35 bis 55 %, vorteilhaft von 40 bis 50 %, liegt.

3. System nach Anspruch 1 oder 2, wobei die Schwellenwerte eine Funktion des optimalen Spannungswertes ($V_{opt}$) der wenigstens einen photovoltaischen Zelle sind.

4. System nach einem der Ansprüche 1 bis 3, wobei die Schwellenwerte eine Funktion der Eingangsspannung der Umsetzer sind, wobei vorteilhaft die Eingangsspannung der optimale Spannungswert ($V_{opt}$) der wenigstens einen photovoltaischen Zelle ist.

5. System nach Anspruch 3 oder 4, wobei die Schwellenwerte eine Funktion der Jahreszeit und/oder der Sonneneinstrahlung sind.

6. System nach einem der Ansprüche 1 bis 5, wobei die Schwellenwerte eine Funktion des Tastgrades der Umsetzer sind.

7. System nach einem der Ansprüche 1 bis 6, wobei die Schwellenwerte eine Funktion der Temperatur der Umsetzer sind.

8. System nach einem der Ansprüche 1 bis 7, wobei die Schwellenwerte eine Funktion der Alterung der Umsetzer sind.

9. System nach einem der Ansprüche 1 bis 8, wobei die Schwellenwerte bestimmt und in dem Speicher des Steuersystems gespeichert werden, wobei die angewendeten Schwellenwerte als Funktion der Messung eines Parameters des photovoltaischen Generators abgewandelt werden können.

10. System nach einem der Ansprüche 1 bis 9, das eine Vorrichtung zum Bestimmen der Wirkungsgradkurve als Funktion der Leistung umfasst.

11. System nach einem der Ansprüche 1 bis 10, wobei das System eine Routine zum Abwechseln der im Betrieb befindlichen Umsetzer umfasst.

12. System nach Anspruch 11, wobei die Abwechslung der Umsetzer während der Veränderung der Anzahl der im Betrieb befindlichen Umsetzer erfolgt.

13. Photovoltaischer Generator, der Folgendes umfasst:

   - wenigstens eine photovoltaische Zelle;
   - das Steuersystem nach einem der Ansprüche 1 bis 12.

14. Verfahren zum Steuern eines photovoltaischen Generators, der Folgendes umfasst:

   - wenigstens eine photovoltaische Zelle;
   - eine Mehrzahl von n parallel geschalteten statischen Umsetzern (11, 12, 13), wobei jeder Umsetzer (11, 12, 13) mit wenigstens einer photovoltaischen Zelle (10) elektrisch verbunden ist, wobei die Anzahl statischer Umsetzer n genannt wird, wobei das Verfahren die folgenden Schritte umfasst:
   - Bestimmen der durch die wenigstens eine photovoltaische Zelle erzeugten Leistung und Vergleichen mit der Spitzenleistung;
   - Vergleichen mit Schwellenwerten P1, P2, ..., Pn - 1;
   - Verbinden von i Umsetzern, wenn der gemessene Leistungswert im Bereich von Pi - 1 und Pi liegt, oder von allen Umsetzern, falls der gemessene Leistungswert größer als Pn - 1 ist,

   **dadurch gekennzeichnet, dass** die Schwellenwerte P1, P2, ..., Pn - 1 als die Werte der Leistung im Wesentlichen im Schnittpunkt von Wirkungsgradkurven für eine zunehmende Anzahl von Umsetzern definiert sind.

15. Verfahren nach Anspruch 14, wobei:

   - der (n - i)-te Umsetzer beim Verbinden der anderen Umsetzer nicht verbunden wird, wenn sämtliche Umsetzer nicht verbunden werden.

16. Verfahren nach Anspruch 15, wobei das Verfahren die folgenden Schritte umfasst:

- Verbinden wenigstens eines ersten Umsetzers;
- Verbinden einer höheren Anzahl von Umsetzern;
- dann beim Verbinden einer weniger hohen Anzahl von Umsetzern nicht Verbinden des ersten Umsetzers.

**17.** Verfahren nach einem der Ansprüche 15 oder 16, wobei der Schritt des Drehens der Umsetzer erfolgt, wenn sich der gemessene Leistungswert zwischen den Schwellenwerten Pi - 1 und Pi ändert.

**18.** Verfahren nach einem der Ansprüche 15 bis 17, wobei das Verfahren die folgenden Schritte umfasst:

- Bestimmen der Nutzungsdauer und/oder der Anzahl von Nutzung jedes Umsetzers;
- Verbinden von Umsetzern in der Weise, dass die Nutzungsdauer und/oder die Nutzungsanzahl für die Umsetzer in einer gegebenen Periode im Wesentlichen gleich sind.

**Claims**

**1.** System for the electronic management of a photovoltaic generator, the system including:

- a plurality of static converters (11, 12, 13) connected in parallel, each converter (11, 12, 13) being electrically connected to at least one photovoltaic cell (10) of said generator, the number of static converters being called n,
- the number of converters connected being determined by comparing the power generated with thresholds P1, P2, ... Pn-1, **characterized in that** these thresholds are defined as the values of the powers substantially at the point of intersection of the efficiency curves for an increasing number of converters.

**2.** System according to claim 1, in which the first threshold is less than 1/3, preferably between 20 and 33%, advantageously between 23 and 32%, and in which the second threshold is less than 2/3, preferably between 35 and 55%, advantageously between 40 and 50%.

**3.** System according to claim 1 or 2, in which the threshold values depend on the optimal voltage value ($V_{opt}$) of said at least one photovoltaic cell.

**4.** System according to any one of claims 1 to 3, in which the threshold values are dependent on the input voltage of the converters, advantageously the input voltage is the optimal voltage value ($V_{opt}$) of said at least one photovoltaic cell.

**5.** System according to claim 3 or 4, in which the threshold values are dependent on the period of the year and/or on the sunshine.

**6.** System according to one of claims 1 to 5, in which the threshold values are dependent on the duty cycle of the converters.

**7.** System according to one of claims 1 to 6, in which the threshold values are dependent on the temperature of the converters.

**8.** System according to one of claims 1 to 7, in which the threshold values are dependent on the aging of the converters.

**9.** System according to one of claims 1 to 8, in which the threshold values are determined and stored in the memory of the management system, the threshold values applied being modifiable as a function of the measurement of a parameter of the photovoltaic generator.

**10.** System according to one of claims 1 to 9, comprising a device for determining the efficiency curve as a function of power.

**11.** System according to one of claims 1 to 10, the system including a rotation routine of the employed converters.

**12.** System according to claim 11, in which the rotation of the converters is effected in the event of variation in the number of converters employed.

**13.** Photovoltaic generator, including:

- at least one photovoltaic cell;
- the management system according to one of claims 1 to 12.

**14.** Method for controlling a photovoltaic generator including:

- at least one photovoltaic cell;
- a plurality of n static converters (11, 12, 13) connected in parallel, each converter (11, 12, 13) being electrically connected to at least one photovoltaic cell (10), the number of static converters being called n;

said method including the steps of:

- determination of the power generated by said at least one photovoltaic cell and comparison with the peak power;
- comparison with threshold values P1, P2, ... Pn-1;
- connection of i converters when the measured power value lies between Pi-1 and Pi or of all the converters if the measured power value is greater than Pn-1,

**characterized in that** said thresholds P1, P2, ... Pn-1 are defined as the values of the powers substantially at the point of intersection of the efficiency curves for an increasing number of converters.

**15.** Method according to claim 14, in which:

- the (n-i)th converter no longer being connected during the connection of the other converters when all the converters are not connected.

**16.** Method according to claim 15, said method including the steps of:

- connection of at least one first converter;
- connection of a higher number of converters;
- then, in the event of the connection of a lower number of converters, said first converter is not connected.

**17.** Method according to either of claims 15 and 16, in which the step of rotation of the converters is carried out when the measured power value changes between the thresholds Pi-1 and Pi.

**18.** Method according to one of claims 15 to 17, said method including the steps of:

- determination of the duration of use and/or of the number of use of each converter;
- connection of the converters such that the duration of use and/or the number of use is more or less equal for the converters over a given period.

Figure 1

Figure 2

14

Générateur PV 10

IL1

↓D1

CS 11

IL2

↓D2

CS 12

Charge 15

IL3

↓D3

CS 13

$C_{IN}$

$C_{OUT}$

Batterie
24 V

$I_{PV}$

$V_{PV}$

$I_{PV}$

$V_{PV}$

Contrôle MPPT 14

D1
D2
D3

**Figure 3**

Puissance PV
85 Wc

P1 $_{CONV.}$ = 28 W

P2 $_{INVENTION}$ = 38 W

P2 $_{CONV.}$ = 56 W

P1 $_{INVENTION}$ = 24 W

Rend.
DC-DC
[%]

Puissance [W]

——— 1 phase

········· 2 phase

— — 3 phase

**Figure 4**

**Figure 5**

**Figure 6**

**EP 2 510 415 B1**

**RÉFÉRENCES CITÉES DANS LA DESCRIPTION**

**Documents brevets cités dans la description**

- EP 1047179 A